# EUROPEAN PATENT APPLICATION

(11) **EP 4 507 481 A1**
(43) Date of publication of application: **12.02.2025**
(21) Application number: 23784301.6
(22) Date of filing: 06.04.2023
(51) Int. Cl.: H10N 50/01, H10N 50/10, H10B 61/00, G11C 11/16

(54) **MANUFACTURING METHOD FOR MAGNETIC MEMORY**

(30) Priority: 08.04.2022 CN 202210366451
(71) Applicant: Jiangsu Leuven Instruments Co., Ltd., Xuzhou, Jiangsu 221300 (CN)
(72) Inventor: ZHENG, Zhiyuan, Xuzhou, Jiangsu 221300 (CN); PENG, Taiyan, Xuzhou, Jiangsu 221300 (CN); YANG, Yuxin, Xuzhou, Jiangsu 221300 (CN); XU, Kaidong, Xuzhou, Jiangsu 221300 (CN)
(74) Representative: Eisenführ Speiser
(86) International application number: PCT/CN2023/086439
(87) International publication number: WO 2023/193738

(57) **Abstract**

The embodiments of the present application disclose a manufacturing method for a magnetic memory, the method comprising: etching laminated layers of a magnetic tunnel junction until a metal layer is reached; oxidizing or nitriding the metal layer and side walls of a free layer and a pinned layer so as to obtain a protective layer; and etching side walls of the protective layer and an oxide layer to remove pollutants on the side wall of the oxide layer. When pollutants on the side wall of the oxide layer are removed by means of etching, the protective layer is used for protecting the side walls of the free layer and the pinned layer, such that etching residues of the free layer and the pinned layer do not attach to the oxide layer, and pollutants on the side wall of the oxide layer can also be removed by means of etching; in addition, since the metal layer is covered by the protective layer, the protective layer is etched first and the etching amount of the metal layer is relatively low, and thus the situation whereby the metal layer is severely damaged or even etched through when etching to remove pollutants on the side wall of the oxide layer is avoided; therefore, pollutants on the side wall of the oxide layer can be removed by means of etching, thereby improving the performance and the yield of a device, and the metal layer can also be prevented from being excessively etched, thereby further improving the yield of the device.

## Description

This application claims priority to Chinese Patent Application No. 202210366451.1, titled "MANUFACTURING METHOD FOR MAGNETIC MEMORY", filed on April 08, 2022 with the China National Intellectual Property Administration, which is incorporated herein by reference in its entirety.

### FIELD

The present disclosure relates to the field of semiconductor, in particular to a method for manufacturing a magnetic random access memory.

### BACKGROUND

With the development of semiconductor-related technologies, random access memory (RAM) has made a great progress. Random access memory includes dynamic random access memory (DRAM), static random access memory (SRAM), flash memory and magnetic random access memory (MRAM). The magnetic random access memory has a higher read-write speed than flash memory, as well as radiation resistance and non-volatility that SRAM and DRAM do not have. Therefore, many storage requirements that currently require a combination of the three types of memory can be met by MRAM alone.

However, when manufacturing magnetic random access memory, there is a low manufacturing yield. Therefore, how to improve the yield of magnetic random access memory is an urgent problem to be solved.

### SUMMARY

In view of the above, an embodiment of the present application provides a method for manufacturing a magnetic random access memory, which can improve the yield of the magnetic random access memory.

An embodiment of the present application provides a method for manufacturing a magnetic random access memory, comprising:
etching a magnetic tunnel junction MTJ lamination to a metal layer, where the MTJ lamination includes a free layer, an oxide layer and a pinned layer laminated in sequence;
oxidizing or nitriding side walls of the free layer and the pinned layer and the metal layer exposed by etching to obtain a protective layer, where the protective layer covers the side walls of the free layer and the pinned layer and covers the metal layer;
etching side walls of the protective layer and the oxide layer to remove contaminants on the side walls of the oxide layer.

In an embodiment, the oxidizing or nitriding side walls of the free layer and the pinned layer and the metal layer exposed by etching to obtain the protective layer includes: oxidizing or nitriding the side walls of the free layer and the pinned layer and the metal layer exposed by etching through introducing an oxidizing gas, a nitriding gas or an alcohol gas to obtain the protective layer.

In an embodiment, he oxidizing gas is selected from one or more of O₂, H₂O₂, O₃, N₂O, and NO; the nitriding gas is selected from one or more of NH₃ and N₂; the alcohol gas is ethanol or methanol.

In an embodiment, a gas flow rate of the oxidizing gas, nitriding gas or alcohol gas is in a range of 10-1000 sccm.

In an embodiment, the oxidizing or nitriding the side walls of the free layer and the pinned layer and the metal layer exposed by etching through introducing the oxidizing gas, the nitriding gas or the alcohol gas to obtain the protective layer includes:
oxidizing or nitriding the side walls of the free layer and the pinned layer and the metal layer exposed by etching through introducing the oxidizing gas, the nitriding gas or the alcohol gas by using an ion beam etching device, an inductively coupled plasma device or a capacitively coupled plasma device to obtain the protective layer.

In an embodiment, the protective layer includes a sidewall protective layer and a bottom protective layer; the sidewall protective layer is located on the side walls of the free layer and the pinned layer, and the bottom protective layer covers the metal layer;
the etching the side walls of the protective layer and the oxide layer to remove contaminants on the side walls of the oxide layer includes:
adjusting an etching angle to make an etching rate of the sidewall protective layer and the oxide layer greater than an etching rate of the bottom protective layer.

In an embodiment, the adjusting the etching angle to make the etching rate of the sidewall protective layer and the oxide layer greater than the etching rate of the bottom protective layer includes:
setting the etching angle with a maximum longitudinal etching rate to make the etching rate of the sidewall protective layer and the oxide layer greater than the etching rate of the bottom protective layer.

In an embodiment, the etching angle is in a range of -75° to 75°.

In an embodiment, etching side walls of the protective layer and the oxide layer to remove contaminants on the side walls of the oxide layer includes:
increasing an etching time to completely remove the contaminants on the side walls of the oxide layer when etching the side walls of the protective layer and the oxide layer.

In an embodiment, the magnetic tunnel junction MTJ lamination is further covered with a shielding layer with a pattern;
the etching the magnetic tunnel junction MTJ lamination to the metal layer includes:
etching the magnetic tunnel junction MTJ lamination to the metal layer by using the shielding layer with the pattern as a mask.

In an embodiment, the protective layer covers side walls and top of the shielding layer.

In an embodiment, a thickness of the protective layer is determined according to a thickness of the oxide layer being contaminated and a thickness of the metal layer.

In an embodiment, the thickness of the protective layer is less than the thickness of the metal layer and greater than the thickness of the oxide layer being contaminated.

In an embodiment, a thickness of the protective layer is in a range of 0.5-50 nm.

In an embodiment, the protective layer is an oxide layer, a nitride layer or a nitride oxide layer; the oxide layer is magnesium oxide.

In an embodiment, a material of the oxide layer in the magnetic tunnel junction MTJ lamination is magnesium oxide.

In an embodiment, the free layer and the pinned layer are made of metal materials, and a material of the metal layer is tantalum.

In an embodiment, the etching the magnetic tunnel junction MTJ lamination to the metal layer includes:
etching the magnetic tunnel junction MTJ lamination to the metal layer by using an ion beam etching process, an inductively coupled plasma process or a capacitively coupled plasma process.

In an embodiment, an etching rate of the protective layer is lower than an etching rate of the metal layer.

In an embodiment, a time for oxidizing or nitriding the side walls of the free layer and the pinned layer and the metal layer exposed by etching is in a range of 5-1000s.

An embodiment of the present application provides a method for manufacturing a magnetic random access memory, including: etching a magnetic tunnel junction MTJ lamination to a metal layer, where the MTJ lamination includes a free layer, an oxide layer and a pinned layer laminated in sequence; oxidizing or nitriding side walls of the free layer and the pinned layer and the metal layer exposed by etching to obtain a protective layer, where the protective layer covers the side walls of the free layer and the pinned layer and covers the metal layer; etching side walls of the protective layer and the oxide layer to remove contaminants on the side walls of the oxide layer. That is, when etching to remove contaminants on the side walls of the oxide layer, the protective layer is used to protect the side walls of the free layer and the pinned layer, and etching residues of the free layer and the pinned layer will not be attached to the oxide layer, and the contaminants on the side walls of the oxide layer can also be etched away. Moreover, as the metal layer is covered by the protective layer, the protective layer will be etched first, and the etching amount of the metal layer is low, thereby avoiding a situation where the metal layer is severely damaged or even pierced when etching to remove contaminants on the side walls of the oxide layer. It can be seen that the method for manufacturing a magnetic random access memory according to the embodiment of the present application can not only etch away contaminants on the side walls of the oxide layer to improve the performance and yield of the device, but also avoid excessive etching of the metal layer, thereby further improving the yield of the device.

### BRIEF DESCRIPTION OF THE DRAWINGS

In order to clearly illustrate technical solutions in the embodiments of the present application or the conventional technology, hereinafter drawings required for the embodiments or the conventional technology description will briefly introduced. Apparently, the drawings described below are some embodiments of the present application. For those skilled in the art, other drawings may also be obtained based on these drawings without creative work.
FIG. 1 is a schematic diagram of a working principle of a magnetic random access memory based on spin-orbit torque.
FIG. 2 is a flow chart of a method for manufacturing a magnetic random access memory gate according to an embodiment of the present application.
FIGs. 3-5 are schematic structural diagrams of a method for manufacturing a magnetic random access memory according to an embodiment of the present application.
FIG. 6 is a schematic structural diagram of a magnetic random access memory according to an embodiment of the present application.
FIG. 7 is a schematic structural diagram of a magnetic random access memory according to another embodiment of the present application.

### DETAILED DESCRIPTION OF EMBODIMENTS

In order to enable those skilled in the art to better understand the technical solution of the present application, the technical solution in the embodiment of the present application will be clearly and completely described below in conjunction with drawings in the embodiment of the present application. Apparently, the described embodiment is only a part of the embodiments of the present application, not all of the embodiments. Based on the embodiments in the present application, all other embodiments obtained by those skilled in the art without creative work are within the scope of protection of the present application.

The present application is described in detail in conjunction with the schematic diagrams. When describing the embodiment of the present application in detail, for the convenience of explanation, the cross-sectional view representing the device structure will not be partially enlarged according to the general proportion, and the schematic diagram is only an example, which should not limit the scope of protection of the present application. In addition, in actual production, the three-dimensional space dimensions of length, width and depth should be included.

With the development of semiconductor-related technologies, random access memory (RAM) has made a great progress. Random access memory includes dynamic random access memory (DRAM), static random access memory (SRAM), flash memory and magnetic random access memory (MRAM). The magnetic random access memory has a higher read-write speed than flash memory, as well as radiation resistance and non-volatility that SRAM and DRAM do not have. Therefore, many storage requirements that currently require a combination of the three types of memory can be met by MRAM alone.

A memory unit of MRAM is magnetic tunnel junction (MTJ), which is a structure that an oxide layer is sandwiched between two layers of magnetic films, e.g. the oxide layer may be magnesium oxide (MgO). One layer of the magnetic films, in which magnetization can remain fixed, is called a pinned layer, and another layer of the magnetic film, in which magnetization can be reversed, is called the free layer. When the magnetic moment directions of the two layers of magnetic films are parallel (P), the resistance (Rₚ) presented by the MTJ is small, and a current can easily pass from the pinned layer to the free layer, and the tunneling current (Iₚ) is large. At this time, the entire MTJ may be regarded as in a conducting state, which represents the binary byte "1". When the magnetic dipole directions of the two layers of magnetic materials are anti-parallel (ap), the resistance (Rₐₚ) is large and the tunneling current (Iₚ) is small. At this time, the entire MTJ can be regarded as in a non-conducting state, which represents the binary byte "0". This is configured to distinguish 0 and 1 in the MTJ storage information.

STT-MRAM, also known as the third-generation MRAM, has advantage of increasing the magnetization density by using the interfacial magnetic anisotropy between magnesium oxide and the magnetic films to make the magnetic moment stand up, namely, the magnetic moment is perpendicular to a film surface. The high density of the magnetic moment is helpful to extend the data retention time and can also be used to reduce the size.

For the current STT specifications, although the data retention time is long and the reliability is high, parameters such as write current (about 50µA), power consumption, and write speed (about 10ns) are not as good as the ideal numbers. The main reason is that the mass of the electron carrying the spin current in the STT reversal mechanism is only 1/1840 of that of the proton. Force or torque is proportional to mass, so even if the current can carry the spin current and generate torque on the magnetic moment, the efficiency will not be too high. The low reversal efficiency leads to slow writing speed, large current and high power consumption. In addition, to provide a large current, a large transistor which is larger than MTJ is required, which is the bottleneck for the miniaturization of memory devices.

The spin angular momentum and atomic orbital angular momentum can interact, but the source of this force or torque is the atomic nucleus. The larger atomic number of an atom, the greater the spin-orbit interaction. Some special materials, such as topological insulators, also have abnormally large spin-orbit interactions on their surfaces. The fourth generation SOT-MRAM uses the spin-orbit torque (SOT) effect to reverse the magnetic moment of the free layer in the MTJ. The characteristic of SOT-MRAM devices is that the switching of the free magnetic layer is completed by injecting in-plane current into the adjacent SOT layer.

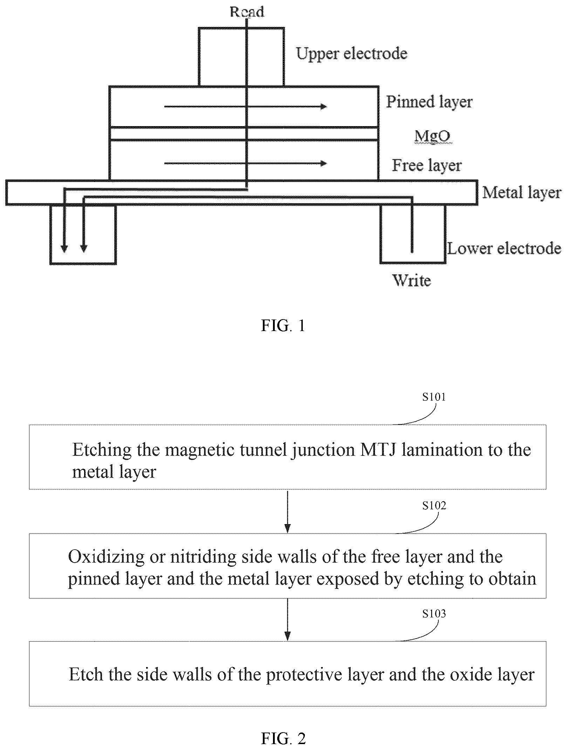

Reference is made to FIG. 1, which is a schematic diagram of a working principle of a magnetic tunnel junction (MTJ) of a magnetic random access memory based on spin-orbit torque SOT. As can be seen from the figure, the read current of SOT-MRAM passes through the magnetic tunnel junction vertically, but the write current relies on the current flowing in the material adjacent to the free layer in parallel, such as the metal layer, to drive the torque generated by the spin-orbit effect on the interface between the free layer and the metal layer to reverse the magnetic moment of the free layer.

Therefore, when manufacturing SOT-MRAM, the technical key points are that: (1) the metal layers below the pinned layers between multiple magnetic tunnel junctions need to be interconnected, and the film layer of the metal layer cannot be broken, otherwise the write function of MRAM will be affected and the yield of device is reduced; (2) the side walls of the magnetic tunnel junction cannot be contaminated with metal to avoid the upper and lower parts of the magnetic tunnel junction being conductive, that is, the pinned layer and the free layer are conductive, causing the magnetic random access memory to malfunction.

The current solution to solve the problem of the key point (1) is to optimize the program parameters during the etching process to ensure that the etching end point can stop at the metal layer and does not penetrate the lower electrode below. The current solution to solve the problem of the key point (2) is to modify the side walls by ion beam etching (IBE), inductively coupled plasma (ICP) or capacitively coupled plasma (CCP) to remove metal contaminants on the side walls of the MgO. However, this method will increase the etching amount of the bottom film layer, that is, the etching amount of the metal layer will increase, and the etching end point will not stop at the expected film, which will eventually lead to the metal layer being etched through. In other words, the solutions to solve the problems of the key point (1) and the key point (2) are not compatible, resulting in a low manufacturing yield in the current manufacturing of magnetic random access memory. Therefore, how to improve the yield of magnetic random access memory is an urgent problem to be solved.

In view of this, an embodiment of the present application provides a method for manufacturing a magnetic random access memory, including: etching a magnetic tunnel junction MTJ lamination to a metal layer, where the MTJ lamination includes a free layer, an oxide layer and a pinned layer laminated in sequence; oxidizing or nitriding side walls of the free layer and the pinned layer and the metal layer exposed by etching to obtain a protective layer, where the protective layer covers the side walls of the free layer and the pinned layer and covers the metal layer; etching side walls of the protective layer and the oxide layer to remove contaminants on the side walls of the oxide layer. That is, when etching to remove contaminants on the side walls of the oxide layer, the protective layer is used to protect the side walls of the free layer and the pinned layer, and etching residues of the free layer and the pinned layer will not be attached to the oxide layer, and the contaminants on the side walls of the oxide layer can also be etched away. Moreover, as the metal layer is covered by the protective layer, the protective layer will be etched first, and the etching amount of the metal layer is low, thereby avoiding a situation where the metal layer is severely damaged or even pierced when etching to remove contaminants on the side walls of the oxide layer. It can be seen that the method for manufacturing a magnetic random access memory according to the embodiment of the present application can not only etch away contaminants on the side walls of the oxide layer to improve the performance and yield of the device, but also avoid excessive etching of the metal layer, thereby further improving the yield of the device.

Reference is made to FIG. 2, which is a flow chart of a method for manufacturing a magnetic random access memory according to an embodiment of the present application. The method for manufacturing the magnetic random access memory in the embodiment includes the following steps:

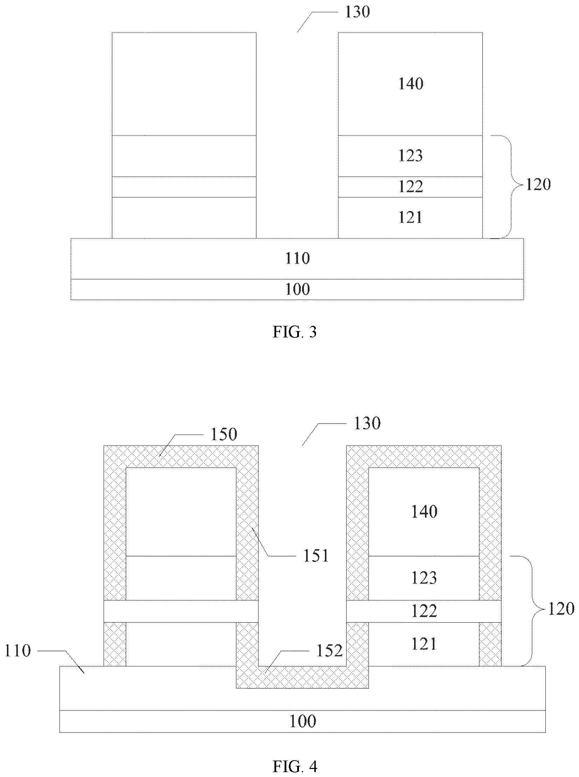

S101, etching the MTJ lamination 120 to the metal layer 110, as shown in FIG. 3.

In an embodiment, the magnetic random access memory includes a substrate 100, a metal layer 110 and an MTJ lamination 120 laminated in sequence. The MTJ lamination 120 includes a free layer 121, an oxide layer 122 and a pinned layer 123 laminated in sequence. The oxide layer 122 may be magnesium oxide, and materials of the free layer 121 and the pinned layer 123 are generally metals. The material of the metal layer 110 may be tantalum (Ta). The substrate 100 may be an oxide, and the substrate 100 may be etched later, and then filled with metal materials to form a lower electrode.

In an embodiment, the MTJ lamination 120 may be etched to the metal layer 110 to obtain an opening 130, which exposes the side walls of the MTJ lamination and the upper surface of the metal layer 110.

Before etching, a shielding layer 140 with a pattern is formed on the MTJ lamination 120, and the MTJ lamination 120 may be etched to the metal layer 110 using the shielding layer 140 with a pattern as a mask.

The MTJ lamination 120 may be etched using an IBE, ICP or CCP machine. Since the MTJ lamination is composed of a variety of metals and metal oxides, after the MTJ lamination 120 is etched, the side walls of the oxide layer 122 will be contaminated with a certain amount of metal, that is, there will be contaminants, and these contaminants will cause the pinned layer and the free layer to be conductive, causing the magnetic random access memory to malfunction, and ultimately affecting the yield of the device.

S102, oxidizing or nitriding the side walls of the free layer 121 and the pinned layer 132 and the metal layer 110 exposed by etching to obtain a protective layer 150, as shown in FIG. 4.

In an embodiment, the side walls of the oxide layer 122 may be etched to remove contaminants on the side walls of the oxide layer 122. Before etching the side walls of the oxide layer 122, a protective layer 150 may be formed on the side walls of the free layer 121 and the pinned layer 132 and the metal layer 110 exposed by etching. That is, the protective layer 150 covers the side walls of the free layer 121 and the pinned layer 123 and covers the metal layer 110.

The etching rate of the protective layer 150 is lower than the etching rate of the metal layer 110, so that when the contaminants on the side walls of the oxide layer 122 are subsequently etched away, the top of the metal layer 110 is protected by the protective layer 150, so the etching damage to the metal layer 110 is small, and the etching amount of the metal layer 110 is low, so as to avoid the situation where the metal layer 110 is pierced when etching to remove contaminants on the side walls of the oxide layer 122.

The protective layer 150 also plays a role in protecting the side walls of the free layer 121 and the pinned layer 132 when etching to remove the contaminants on the side walls of the oxide layer 122, thereby preventing the metal residues of the free layer 121 and the pinned layer 132 from adhering to the oxide layer 122, causing the pinned layer 121 and the free layer 123 to be conductive, causing the magnetic random access memory to malfunction, and ultimately affecting the yield of the device.

The process of forming the protective layer 150 may be oxidizing or nitriding the side walls and bottom of the opening 130, namely, oxidizing or nitriding the side walls of the free layer 121 and the pinned layer 132 and the metal layer 110 exposed by etching to obtain the protective layer 150.

Specifically, during oxidizing or nitriding, in addition to forming the protective layer 150 on the side walls of the free layer 121 and the pinned layer 132 and the metal layer 110 exposed by etching, the protective layer 150 is also formed on the side walls and top of the shielding layer 140.

In an embodiment, an oxidizing gas, a nitriding gas or an alcohol gas may be introduced to oxidize or nitride the side walls of the free layer 121 and the pinned layer 123 and the metal layer 110 exposed by etching to obtain the protective layer 150. The protective layer 150 may be an oxide layer, a nitride layer or a nitride oxide layer. That is, the material of the protective layer 150 may be an oxide, a nitride or a nitride oxide, depending on which gas is used to form the protective layer.

The oxidizing gas may be any one or more of O₂, H₂O₂, O₃, N₂O, and NO, the nitriding gas may be one or more of NH₃ and N₂, and the alcohol gas may be ethanol or methanol.

The oxidizing or nitriding device may be IBE, ICP, CCP, or HMOP.

In an embodiment, the oxidizing or nitriding device is an IBE device, the process parameters of oxidizing or nitriding may be set as follows:
1. Accelerated grid voltage BMV: 50V-1500V.
2. Deflection grid voltage ACV: 50-1500V.
3. Gas flow rate: 10-500sccm.
4. Angle: -45° to 45°
5. Time: 10s-1000s.

In another embodiment, the oxidizing or nitriding device is an ICP device, the process parameters of oxidizing or nitriding may be set as follows:
1. Upper electrode power Ws: 50-3000W.
2. Bottom electrode power Wb: 0-1500W.
3. Gas flow rate: 10-1000sccm.
4. Time: 5s-1000s.
5. Chamber pressure: 1-100mT.
6. Temperature: 0-80°C.

In another embodiment, the oxidizing or nitriding device is a CCP device, the process parameters of oxidizing or nitriding may be set as follows:
1. Electrode power Ws: 50-3000W.
2. Gas flow rate: 10-1000sccm.
3. Time: 5s-1000s.
4. Chamber pressure: 10-200mT.
5. Temperature: 0-80°C.

The purpose of setting the process parameters of the oxidizing or nitriding in the above embodiment is to form a protective layer 150 on the side wall and bottom of the opening 130 to slow down the etching rate of the bottom of the opening 130 during subsequent etching.

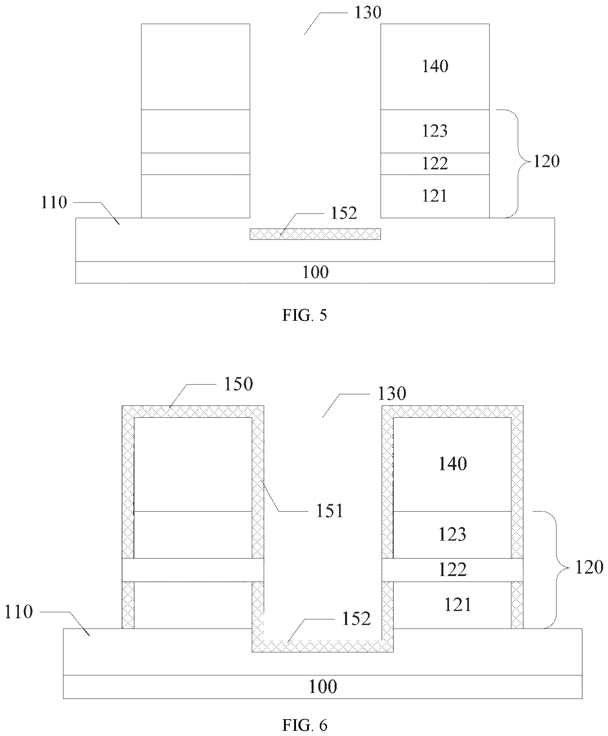

S103, etching the side walls of the protective layer 150 and the oxide layer 122, as shown in FIG. 5.

In an embodiment, after the protective layer 150 is formed, the side walls of the protective layer 150 and the oxide layer 122 may be etched to remove contaminants on the side walls of the oxide layer 122. As the protective layer 150 is formed on the metal layer 110, and the etching rate of the protective layer 150 is lower, the etching rate (ER1) of the film at the bottom of the opening 130 will be slowed down, so that the time to etch through the metal layer 110 at the bottom of the opening 130 is increased, so that the contaminants on the sidewall of the oxide layer 122 are removed more cleanly and the metal layer 110 will not be etched through.

In an embodiment, the protective layer 150 may include a sidewall protective layer 151 and a bottom protective layer 152. The sidewall protective layer 151 is located on the side walls of the free layer 121 and the pinned layer 123, and the bottom protective layer 152 covers the metal layer 110. That is, the sidewall protective layer 151 is located on the side walls of the opening 130, and the bottom protective layer 152 is located at the bottom of the opening 130.

In order to completely remove the contaminants on the side walls of the oxide layer 122, there are two possible implementation methods:
The first implementation method is to increase the etching time. When the side walls of the protective layer 150 and the oxide layer 122 are etched, if the contaminants on the side walls of the oxide layer 122 are completely removed, the bottom protective layer 152 or the sidewall protective layer 151 may be completely etched away, even the bottom protective layer 150 may be completely etched away and the metal layer 110 may continue to be etched. Although the metal layer 110 will not be etched through due to the protection of the bottom protective layer 150, it will still cause a large amount of metal layer 110 to be etched.

The second implementation method is to adjust the etching angle to make the etching rate of the sidewall protective layer 151 and the side walls of the oxide layer 122 greater than the etching rate of the bottom protective layer 152, so that when the contaminants on the side walls of the oxide layer 122 are completely removed, the etching amount of the bottom of the opening 130 is small to further protect the metal layer 110 and avoid a large etching amount of metal layer 110.

Specifically, an etching angle with a maximum longitudinal etching rate may be set to make the etching rate of the sidewall protection layer 151 and the oxide layer 122 greater than the etching rate of the bottom protection layer 152. That is, by setting the angle with a larger etching rate on the side walls of the opening 130, the etching rate on the bottom of the opening 130 is lower, which can meet the purpose of less etching amount at the bottom of the opening 130 after the contaminants on the side wall of the oxide layer 122 are etched. The etching angle may be in a range of -75° to 75°.

In practical applications, it is necessary to design a suitable thickness of the protective layer 150 to avoid the protective layer 150 being too thick, which makes it difficult to clean the sidewall protective layer 151 later, and to avoid the protective layer 150 being too thin, which results in the side walls of the free layer 121 and the pinned layer 123 being exposed before the contaminants on the side walls of the oxide layer 122 are completely etched away. Therefore, the thickness of the protective layer 150 may be determined according to the thickness of the oxide layer being contaminated and the thickness of the metal layer 110. That is, the thickness of the protective layer 150 is less than the thickness of the metal layer 110 to prevent the metal layer 110 from being completely oxidized, and the thickness of the protective layer 150 is greater than the thickness of the oxide layer 122 being contaminated.

Specifically, the thickness of the protective layer may be in a range of 0.5 to 50 nm.

In an embodiment, the thickness of the metal layer 110 is 10 nm, the thickness of the oxide layer 122 being contaminated is 3 to 4 nm, and the thickness of the protective layer may be 5 to 6 nm.

In order to verify the etching effect, 6 possible implementation methods are provided according to the embodiments of the present application below.

The first possible implementation method is to etch the MTJ lamination 120 using an etching machine; the process parameters of etching may be: ICP: 5mT/0C/250Ws/260Wb/150Ar/8s, IBE: 400VBMV/400V ACV/-75D/42s and IBE: 100V BMV/400V/ACV/70D/1002s. Then, oxidizing is performed; the process parameters of oxidizing may be: ICP: 5mT/0C/300Ws/0Wb/150O₂/720s. The thickness of the protective layer 150 obtained by oxidizing is about 5nm. Then, the side walls of the protective layer 150 and the oxide layer 122 are etched; the specific process parameters of etching may be: IBE: 400VBMV/400V ACV/-35D/200s. From these parameters, it can be seen that the etching time is 200s. The etching effect is shown in FIG. 6. It can be seen from FIG. 6 that after the oxidation treatment, the etching may be stopped at the metal layer 110, and the side walls of the oxide layer 122 is relatively clean. That is, after the oxidation treatment, the yield of the SOT-MRAM device can be improved. After the etching, a part of the oxide remains on the top of the metal layer 110, the top of the shielding layer 140, the side walls of the shielding layer 140, and the side walls of the free layer 121 and the pinned layer 123.

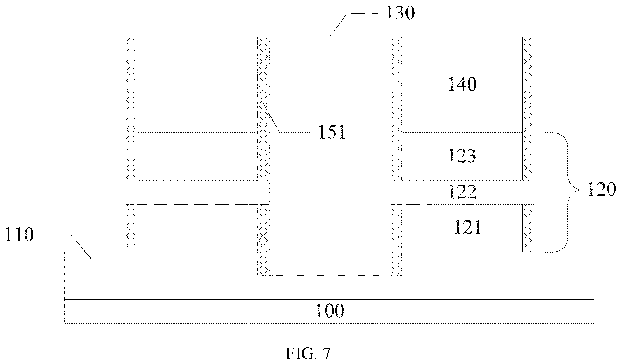

The second possible implementation method is to etch the MTJ lamination 120 using an etching machine; the process parameters of etching may be: ICP: SmT/OC/250Ws/260Wb/150Ar/8s, IBE: 400VBMV/400V ACV/-75D/42s and IBE: 100V BMV/400V/ACV/70D/1002s. Then, oxidizing is performed; the process parameters of oxidizing may be: ICP: 5mT/0C/300Ws/0Wb/150O₂/360s. The thickness of the protective layer 150 obtained by oxidizing is about 2.5nm. Then, the side walls of the protective layer 150 and the oxide layer 122 are etched; the specific process parameters of etching may be: IBE: 400VBMV/400V ACV/-35D/200s. From these parameters, it can be seen that the etching time is 200s. The etching effect is shown in FIG. 7. It can be seen from FIG. 7 that after the oxidation treatment, the etching may be stopped at the metal layer 110, and the side walls of the oxide layer 122 is relatively clean. That is, after the oxidation treatment, the yield of the SOT-MRAM device can be improved. The oxides on the top of the shielding layer 140 and the top of the metal layer 110 are etched cleanly, and a part of the oxide remains on the side walls of the shielding layer 140 and the side walls of the free layer 121 and the pinned layer 123.

The third possible implementation method is to etch the MTJ lamination 120 using an etching machine; the process parameters of etching may be: ICP: 5mT/0C/250Ws/260Wb/150Ar/8s, IBE: 400VBMV/400V ACV/-75D/42s and IBE: 100V BMV/400V/ACV/70D/1002s. Then, oxidizing is performed; the process parameters of oxidizing may be: ICP: 5mT/0C/300Ws/0Wb/150O₂/360s. The thickness of the protective layer 150 obtained by oxidizing is about 2.5nm. Then, the side walls of the protective layer 150 and the oxide layer 122 are etched; the specific process parameters of etching may be: IBE: 400V BMV/400V ACV/-65D/400s. From these parameters, it can be seen that the etching angle increases from -35D to -65D, and the etching time is 400s. The etching effect is shown in FIG. 5. It can be seen from FIG. 5 that after the oxidation treatment, the etching may be stopped at the metal layer 110, and the side walls of the oxide layer 122 is relatively clean. That is, after the oxidation treatment, the yield of the SOT-MRAM device can be improved. The oxides on the top of the shielding layer 140, the side walls of the shielding layer 140, the side walls of the free layer 121 and the pinned layer 123 are etched cleanly, and a part of the oxide remains on the top of the metal layer 110.

It can be seen from the above three implementation effects that different thicknesses of the protective layer 150 can be obtained through changing the oxidation time. The protective layer 150 with different thicknesses may affect the residual morphology of the protective layer 150 after the final etching. Under the same oxidation conditions, extending the etching time or increasing the etching angle can reduce the residual of the protective layer 150 on the surface of the device, especially can reduce the residual of the protective layer 150 on the side walls of the free layer 121 and the pinned layer 123.

The fourth possible implementation method is to etch the MTJ lamination 120 using an etching machine; the process parameters of etching may be: ICP: 5mT/0C/250Ws/260Wb/150Ar/8s, IBE: 400VBMV/400V ACV/-75D/42s and IBE: 100V BMV/400V/ACV/70D/1002s. Then, nitriding is performed; the process parameters of nitriding may be: ICP: 5mT/0C/300Ws/0Wb/150N₂/360s. The thickness of the protective layer 150 obtained by nitriding is about 4nm. Then the side walls of the protective layer 150 and the oxide layer 122 are etched; the specific process parameters of etching may be: IBE: 400VBMV/400V ACV/-35D/200s. From these parameters, it can be seen that the etching angle is -35D and the etching time is 200s. The etching effect is shown in FIG. 6. It can be seen from FIG. 6 that after the nitriding treatment, the etching may be stopped at the metal layer 110, and the side walls of the oxide layer 122 are relatively clean. That is, after the nitriding treatment, the yield of the SOT-MRAM device can be improved. A part of the nitride remains on the top of the shielding layer 140, the side walls of the shielding layer 140, and the top of the metal layer 110.

The fifth possible implementation method is to etch the MTJ lamination 120 using an etching machine; the process parameters of etching may be: ICP: 5mT/0C/250Ws/260Wb/150Ar/8s, IBE: 400VBMV/400V ACV/-75D/42s and IBE: 100V BMV/400V/ACV/70D/1002s. Then, nitriding is performed; the process parameters of nitriding may be: ICP: 5mT/0C/300Ws/0Wb/150N₂/360s. The thickness of the protective layer 150 obtained by nitriding is about 4nm. Then the side walls of the protective layer 150 and the oxide layer 122 are etched; the specific process parameters of etching may be: IBE: 400VBMV/400V ACV/-15D/400s. From these parameters, it can be seen that the etching angle is -15D and the etching time is 400s. The etching effect is shown in FIG. 7. It can be seen from FIG. 7 that after the nitriding treatment, the etching may be stopped at the metal layer 110, and the side walls of the oxide layer 122 is relatively clean. That is, after the nitriding treatment, the yield of the SOT-MRAM device can be improved. A part of the nitride remains on the side walls of the shielding layer 140, the free layer 121 and the pinned layer 123, but no nitride remains on the top of the metal layer 110.

The sixth possible implementation method is to etch the MTJ lamination 120 using an etching machine; the process parameters of etching may be: ICP: 5mT/0C/250Ws/260Wb/150Ar/8s, IBE: 400VBMV/400V ACV/-75D/42s and IBE: 100V BMV/400V/ACV/70D/1002s. Then, nitriding is performed; the process parameters of nitriding may be: ICP: 5mT/0C/300Ws/0Wb/150N₂/360s. The thickness of the protective layer 150 obtained by nitriding is about 4nm. Then the side walls of the protective layer 150 and the oxide layer 122 are etched; the specific process parameters of etching may be: IBE: 400V BMV/400V ACV/-65D/400s. From these parameters, it can be seen that the etching angle is -65D and the etching time is 400s. The etching effect is shown in FIG. 5. It can be seen from FIG. 5 that after the nitriding treatment, the etching may be stopped at the metal layer 110, and the side walls of the oxide layer 122 are relatively clean. That is, after the nitriding treatment, the yield of the SOT-MRAM device can be improved. There is no nitride residue on the side walls of the shielding layer 140, the free layer 121 and the pinned layer 123, but there is nitride residue on the top of the metal layer 110.

It can be seen from the above three effects of implementation methods that under the same nitriding conditions, the amount of nitride residue on the surface of the device may be reduced through extending the etching time. Under the same nitriding conditions, changing the IBE main etching angle, i.e., increasing the IBE main etching angle, may make the nitride residue on the side walls of the free layer 121 and the pinned layer 123 less, and the amount of nitride residue on the top of the metal layer 110 may increase.

An embodiment of the present application provides a method for manufacturing a magnetic random access memory, including: etching a magnetic tunnel junction MTJ lamination to a metal layer, where the MTJ lamination includes a free layer, an oxide layer and a pinned layer laminated in sequence; oxidizing or nitriding side walls of the free layer and the pinned layer and the metal layer exposed by etching to obtain a protective layer, where the protective layer covers the side walls of the free layer and the pinned layer and covers the metal layer; etching side walls of the protective layer and the oxide layer to remove contaminants on the side walls of the oxide layer. That is, when etching to remove contaminants on the side walls of the oxide layer, the protective layer is used to protect the side walls of the free layer and the pinned layer, and etching residues of the free layer and the pinned layer will not be attached to the oxide layer, and the contaminants on the side walls of the oxide layer can also be etched away. Moreover, as the metal layer is covered by the protective layer, the protective layer will be etched first, and the etching amount of the metal layer is low, thereby avoiding a situation where the metal layer is severely damaged or even pierced when etching to remove contaminants on the side walls of the oxide layer. It can be seen that the method for manufacturing a magnetic random access memory according to the embodiment of the present application can not only etch away contaminants on the side walls of the oxide layer to improve the performance and yield of the device, but also avoid excessive etching of the metal layer, thereby further improving the yield of the device.

When elements of various embodiments of the present application are introduced, the articles "a", "an", "this" and "the" are intended to indicate one or more elements. The words "including", "comprising" and "having" are all inclusive and mean that there may be other elements in addition to the listed elements.

The above is only a preferred embodiment of the present application. Although the present application has been disclosed as above with preferred embodiments, they are not intended to limit the present application. Any person skilled in the art can make many possible changes and modifications to the technical solution of the present application or modify the above content into an equivalent embodiment with equivalent changes through using the above disclosed methods and technical contents without departing from the scope of the technical solution of the present application. Therefore, any simple modification, equivalent change and modification made to the above embodiments according to the technical essence of the present application without departing from the content of the technical solution of the present application still fall within the scope of protection of the technical solution of the present application.

## Claims

1. A method for manufacturing a magnetic random access memory, comprising:
etching a magnetic tunnel junction (MTJ) lamination to a metal layer, wherein the MTJ lamination comprises a free layer, an oxide layer and a pinned layer laminated in sequence;
oxidizing or nitriding side walls of the free layer and the pinned layer and the metal layer exposed by etching to obtain a protective layer, wherein the protective layer covers the side walls of the free layer and the pinned layer and covers the metal layer;
etching side walls of the protective layer and the oxide layer to remove contaminants on the side walls of the oxide layer.

2. The method according to claim 1, wherein the oxidizing or nitriding side walls of the free layer and the pinned layer and the metal layer exposed by etching to obtain the protective layer comprises:
oxidizing or nitriding the side walls of the free layer and the pinned layer and the metal layer exposed by etching through introducing an oxidizing gas, a nitriding gas or an alcohol gas to obtain the protective layer.

3. The method according to claim 2, wherein the oxidizing gas is selected from one or more of O₂, H₂O₂, O₃, N₂O, and NO; the nitriding gas is selected from one or more of NH₃ and N₂; the alcohol gas is ethanol or methanol.

4. The method according to claim 2, wherein a gas flow rate of the oxidizing gas, nitriding gas or alcohol gas is in a range of 10-1000 sccm.

5. The method according to claim 2, wherein the oxidizing or nitriding the side walls of the free layer and the pinned layer and the metal layer exposed by etching through introducing the oxidizing gas, the nitriding gas or the alcohol gas to obtain the protective layer comprises:
oxidizing or nitriding the side walls of the free layer and the pinned layer and the metal layer exposed by etching through introducing the oxidizing gas, the nitriding gas or the alcohol gas by using an ion beam etching device, an inductively coupled plasma device or a capacitively coupled plasma device to obtain the protective layer.

6. The method according to claim 1, wherein the protective layer comprises a sidewall protective layer and a bottom protective layer; the sidewall protective layer is located on the side walls of the free layer and the pinned layer, and the bottom protective layer covers the metal layer;
the etching the side walls of the protective layer and the oxide layer to remove contaminants on the side walls of the oxide layer comprises:
adjusting an etching angle to make an etching rate of the sidewall protective layer and the oxide layer greater than an etching rate of the bottom protective layer.

7. The method according to claim 6, wherein the adjusting the etching angle to make the etching rate of the sidewall protective layer and the oxide layer greater than the etching rate of the bottom protective layer comprises:
setting the etching angle with a maximum longitudinal etching rate to make the etching rate of the sidewall protective layer and the oxide layer greater than the etching rate of the bottom protective layer.

8. The method according to claim 6 or 7, wherein the etching angle is in a range of -75° to 75°.

9. The method according to claim 1, wherein etching side walls of the protective layer and the oxide layer to remove contaminants on the side walls of the oxide layer comprises:
increasing an etching time to completely remove the contaminants on the side walls of the oxide layer when etching the side walls of the protective layer and the oxide layer.

10. The method according to any one of claims 1 to 9, wherein the magnetic tunnel junction MTJ lamination is further covered with a shielding layer with a pattern;
the etching the magnetic tunnel junction MTJ lamination to the metal layer comprises:
etching the magnetic tunnel junction MTJ lamination to the metal layer by using the shielding layer with the pattern as a mask.

11. The method according to claim 10, wherein the protective layer covers side walls and top of the shielding layer.

12. The method according to any one of claims 1 to 9, wherein a thickness of the protective layer is determined according to a thickness of the oxide layer being contaminated and a thickness of the metal layer.

13. The method according to claim 12, wherein the thickness of the protective layer is less than the thickness of the metal layer and greater than the thickness of the oxide layer being contaminated.

14. The method according to any one of claims 1 to 9, wherein a thickness of the protective layer is in a range of 0.5-50 nm.

15. The method according to any one of claims 1 to 9, wherein the protective layer is an oxide layer, a nitride layer or a nitride oxide layer; the oxide layer is magnesium oxide.

16. The method according to any one of claims 1 to 9, wherein a material of the oxide layer in the magnetic tunnel junction MTJ lamination is magnesium oxide.

17. The method according to any one of claims 1 to 9, wherein the free layer and the pinned layer are made of metal materials, and a material of the metal layer is tantalum.

18. The method according to any one of claims 1 to 9, wherein the etching the magnetic tunnel junction MTJ lamination to the metal layer comprises:
etching the magnetic tunnel junction MTJ lamination to the metal layer by using an ion beam etching process, an inductively coupled plasma process or a capacitively coupled plasma process.

19. The method according to any one of claims 1 to 9, wherein an etching rate of the protective layer is lower than an etching rate of the metal layer.

20. The method according to any one of claims 1 to 9, wherein a time for oxidizing or nitriding the side walls of the free layer and the pinned layer and the metal layer exposed by etching is in a range of 5-1000s.
